# EUROPEAN PATENT SPECIFICATION

(11) **EP 0 528 986 B1**
(45) Date of publication and mention of the grant of the patent: **29.10.1997**
(21) Application number: 91911116.1
(22) Date of filing: 13.05.1991
(51) Int. Cl.: B05C 13/00, B05C 13/02, C23C 16/00, B32B 9/00

(54) **MATERIALS FOR CHEMICAL VAPOR DEPOSITION PROCESSES**
WERKSTOFFE FÜR CDV-VERFAHREN
MATERIAUX DESTINES AUX PROCEDES CHIMIQUES DE DEPOT EN PHASE GAZEUSE

(30) Priority: 18.05.1990 US 526095
(43) Date of publication of application: 03.03.1993
(73) Proprietor: HITCO TECHNOLOGIES INC., City of Gardena, Los Angeles, California 90249 (US)
(72) Inventor: JOHNSON, Frederick, Q., San Jose, CA 95148 (US); MOSHER, Paul, V., Redondo Beach, CA 90278 (US)
(74) Representative: Silverman, Warren
(86) International application number: US9103336
(87) International publication number: WO9117839

(56) References cited:
- EP-A- 0 290 322
- DE-A- 3 327 659
- GB-A- 2 197 618
- US-A- 4 397 901
- US-A- 4 425 407
- US-A- 4 465 777
- US-A- 4 472 476
- US-A- 4 476 164
- US-A- 4 476 178
- US-A- 4 487 799
- US-A- 4 500 602
- US-A- 4 515 860
- US-A- 4 585 675
- US-A- 4 599 256
- US-A- 4 671 997
- US-A- 4 795 677
- US-A- 4 863 773
- US-A- 4 868 056
- US-A- 4 894 286
- DATABASE WPI Derwent Publications Ltd., London, GB; AN 89 353173 C48 & JP-A-1 264 964 (TOYO TANSO KK) 23 October 1989
- CHEMICAL ABSTRACTS vol. 109, no. 16 , October 1989 , OHIO USA , XP57784 KIYOSHI ET AL 'MANUFACTURE OF CARBON-FIBER-REINFORCED CARBON COMPOSITES' ABSTRACT NO 133898q
- Ceramic Bulletin, Vol. 67, No. 2, 1988, STRIFE et al., "Ceramic Coatings for Carbon-Carbon Composites", pages 369-374.

## Description

The present invention relates to materials useful as furniture and reactor parts for chemical vapor deposition (CVD) processes. More particularly, it relates to carbon/carbon composite materials, optionally having a coating of silicon, used for reactor and/or handling parts and furniture in CVD processes.

Chemical vapor deposition (CVD) processes are used in the manufacture of integrated circuits, thin films, refractory coatings and the like, under conditions at which a surface can be deposited or coated with the vapors of volatile chemical species. Materials used in CVD reactor or furnace parts or as carriers for the substrate must be able to withstand temperatures of between 200-2000°C, either oxidizing or reducing chemical environments and, for plasma-enhanced chemical vapor deposition (PECVD) significant electric discharge voltage differentials and the energy and etching effects of the induced plasma.

Several classes of CVD processes are thermally activated; thus the surface to be coated must be heated for the deposition to occur. These include low-pressure chemical vapor deposition (LPCVD) processes in which the reaction is controlled by the temperature of the surfaces of the substrate, the carrier and reactor. LPCVD processes include the reducing environment depositions of polysilicon on silicon wafers, both doped and undoped, at temperatures of about 550°C to about 700°C and pressures of about 0.2 torr to about 0.6 torr, and silicon nitride on silicon wafers, both doped and undoped, at temperatures of about 700°C to about 800°C and pressures of about 0.2 torr to about 0.4 torr. Also included is the high-temperature oxidizing environment depositions of tetraethylorthosilicate at about 700° to about 800°C and at a pressure of about 0.5 torr to about 1 torr, and of other high-temperature oxides from silane and nitrous oxide or dichlorosilane and oxygen. LPCVD pressures generally range from about 0.3 torr to 2 torr.

In these processes it is critical for the formation of high-quality depositions that the substrates, such as semiconductor wafers, be held at both a uniform temperature and a uniform separation.

Other CVD processes are diffusion controlled. The deposition reaction is controlled by the supply of gas or vapor as well as the substrate surface temperature. These processes are significantly geometry dependent. Uniformity of deposition is dependent on each reactive surface, such as semiconductor waters, being disposed equidistantly from another reactive surface. In order to accomplish this, elaborate wafer carriers are used to hold wafers back-to-back such that each wafer face "sees" another wafer face equidistantly. The wafer carriers, or "cages," must be made of material that can be prepared to precise tolerances in order to hold the geometry uniform, and thus to permit uniform deposition. The deposition of high-quality material requires that the carriers have no more than about a 2% variation geometrically. Examples of this type of process include low-temperature oxide depositions of films (coatings) of borosilicate glass (BSG), phosphosilicate glass (PSG), borophosphosilicate glass (BPSG) and doped polysilicon on silicon wafers. These depositions are typically conducted at pressures of about 0.2 torr to about 0.5 torr, and temperatures of about 350°C to about 450°C, preferably about 400°C to about 425°C, except for doped polysilicon which is deposited at temperatures of about 550° to about 680°C.

Types of CVD furnaces include the horizontal batch and continuous process furnaces and the vertical, cylindrical and tubular batch process furnaces. The substrates to be coated are placed on a rotating susceptor plate for uniformity of deposition in the vertical furnace, are held peripherally in the cylindrical furnace and are held in carriers in the tubular furnace. The furnaces may contain an external radio frequency (rf) induction coil that couples energy through the furnace wall to the susceptor to heat the substrate, such as in reactors for growing epitaxial films, or an external radiant heating coil around the furnace. Other furnaces have resistance heaters to heat the substrate via internal directed radiation.

The depositions described above, and others, can be produced by plasma-enhanced chemical vapor deposition (PECVD). A lover operating temperature is possible because of the energy present in the plasma which enhances formation of chemical species for deposition. Required for PECVD are electrically conductive, chemically inert plates on which to dispose the substrate.

PECVD processes are generally carried out at pressures of about 0.2 torr to 5 torr, preferably 0.2 torr to about 0.5 torr, and at temperatures of about 250°C to about 500°C, preferably about 400°C to about 500°C. Examples of depositions produced in this way are amorphous silicon films for solar cells and passivating films of SiO₂, SiO₂-Si₃N₄ and Si₃N₄ for semiconductor fabrication.

Although low-pressure CVD processes are described above, CVD is also operated at or near atmospheric pressure for deposition of films and coatings such as Si epitaxy, Si₃N₄, polysilicon and SiO₂. These high-pressure CVD processes are generally carried out at temperatures from about 400°C to about 1200°C. Particularly, SiO₂ can be deposited at about 400°C, Si₃N₄ at about 850°C and epitaxy Si (used in bipolar devices) at about 1100°C.

CVD processes involve the contacting of the substrate to be treated with a vapor of the material to be deposited or coated. As the vapor flows in and through the reactor to make such contact, any particles of impurities or debris from the current or previous deposition can be carried onto the substrate, causing a reduction in the number of acceptable pieces fabricated. For example, in the production of integrated circuits on semiconductor wafers, during the masking process a photoresist is spun onto the wafer surface to a thickness of 1-2 microns. Particles in the 1-2 micron range are often generated in the CVD process due to nucleation of the vapor on reactor and furniture surfaces, as will be detailed below, and are carried along with the process gas or vapor. When such particles adhere to the wafer surface, and are incorporated into this photoresist layer, they can cause problems in the exposure of the pattern to be etched in several ways.

First, areas which were intended to be exposed for optical printing may be withheld from the exposing light, rendering the pattern and resulting circuit incomplete. Second, during light exposure, the particles may be the source of secondary reflection which causes undesired exposure of areas of photoresist which can result in short circuits after fabrication. The reduction in the number of 1-2 micron particles produced during semiconductor wafer CVD fabrication is therefore critical.

Deposition furniture and reactor parts, such as boats, cages, trays and other carriers, plates, susceptors, rails, nests, cantilevered rods, liners, support rods and other handling and jigging equipment have in the past been made of alumina, aluminum, stainless steel, quartz or graphite.

Due to the high temperature of the CVD process and the need for high purity in the process gas, conventional lubrication is not feasible. The substrate carriers are often moved in and out of the hot section of the reactor on either a sled (which may be slid on rails scraping the reactor walls or rolled in on wheels which generate chips and flakes from the reactor walls) or a set of two or three cantilevered rods (made, for example, from dense alumina or silicon carbide and sheathed in quartz) which may or may not rest on the reactor wall during operation (soft landed). Moving these parts causes the generation of small friction particles which can be carried with the process gas into contact with the substrate.

Quartz reactor parts and furniture also result in particle nucleation and contamination problems for additional reasons. Quartz is relatively transparent to the thermal and R-F radiation spectrum utilized to heat the substrates for CVD, and therefore presents a "cold" surface to the process gas. Instead of uniformly depositing in a film on the quartz reactor parts and furniture, as well as the substrate, the gas contacts the cold surface and nucleates into particles which may then peel off or dislodge and enter the process gas stream or deposit on the substrate.

Because the quartz does not heat appreciably under the CVD process conditions in which convection is not a vehicle for energy transfer, it may take hours for the reactor to stabilize at the deposition temperature. In fact, the heated substrates often are the vehicle by which the quartz carrier, in contact with and holding the substrates, is heated.

Quartz has a further drawback, in that no two pieces of quartz equipment are exactly the same due to the nature of the material and the method of preparation. The best tolerances expected for an average, specified dimension of a quartz piece is about 3%. Quartz material used for wafer cages is generally specified to be on the order of 108-110 mm diameter. At a 3% tolerance factor, pieces meeting that specification could in reality be from about 104-3/4 to 113-1/3 mm diameter. Since quartz cannot easily be cut or machined, the variances in piece size frustrate the geometric uniformity requirements of substrate separation needed to obtain optimally uniform deposition onto the substrates.

Bulk graphite or pyrolitic carbon parts also exhibit uniformity problems, as no two pieces of graphite are identical. Graphite parts are also extremely heavy, yet extremely fragile, in addition to being the source of particulate impurities. It has been attempted to reduce the impurity factor by depositing a refractory coating, such as SiC onto the graphite. The coating does not adhere well to the graphite however, and sandblasting, a source of more particulate matter, must be utilized to increase adherence. Semiconductor wafers made using graphite furniture generally exhibit an 8% uniformity variation overall (that is, overall uniformity of deposition on the wafer).

One further drawback to the use of the above materials for CVD processes is the frequency of required cleanings for acceptable operation. Quartz parts (including furniture) must be cleaned after every five to eight operating runs; graphite usually must be cleaned after every six runs. There is usually about 20% breakage during the cleaning operation, and most parts are discarded after three cleanings. Cleaning takes place in hydrofluoric acid, which is highly reactive and difficult to handle, contributing to disposal, problems. Also, cleaning of the quartz results in substantial etching of the parent material, with a corresponding deleterious effect on the dimensional tolerances of the quartzware.

New materials are being introduced to construct furniture such as wafer cages to overcome some of the problems with quartzware. Hot pressed silicon carbide and silicon carbide fiber reinforced silicon carbide reinforced silicon carbide cages have been constructed which would appear to reduce particle formation, but these materials have, to date, been fragile and not readily applicable to automatic transfer machinery associated with semiconductor wafer processing. Also, the materials have to be cleaned by acid etch routinely.

Finally, JP-A-1 264 964 (DATABASE WP1 Derwent Publications Ltd, London, AN 89 35 3173 C 84) describes the use of thermal shock resistant carbon composites comprising carbonaceous felt impregnated with pyrolysed carbon as structural material of, *inter alia*, a CVD boat. Moreover EP-A-0290322 describes a cartridge for producing single crystals by oriented solidification involving, pulling a single crystal from a melt of molten material, the cartridge having a cylindrical partition formed, *inter alia*, of carbon impregnated carbon fibre material.

According to the present invention, there is provided a chemical vapour deposition process for the uniform deposition of one or more volatile species onto at least one semiconductor wafer in the presence of at least one CVD processing part, characterised in that the process is modified by having at least one such CVD part in direct contact with the semiconductor wafer and/or by promoting film deposition over particle formation during the chemical vapour deposition, thereby to avoid outgassing and suppress impurity particle formation on the semiconductor wafer, said at least one CVD part comprising a carbon fibre-reinforced carbon matrix material providing dimensional stability to said part and capable of maintaining precise tolerances as temperatures change and when subject to reaction conditions.

It has now been found that carbon fiber reinforced carbon matrix materials (carbon-carbon composites) are excellent when used in CVD processes for deposition of at least one or more volatile chemical species onto at least one semiconductor wafer. Carbon-carbon composites maintain precise tolerances under changing temperature and reaction conditions, being chemically inert to reducing environments. They possess strength and toughness at CVD operating temperatures. Carbon-carbon composites have the effect of being a "black body" to the radiation wavelengths encountered at these temperatures, significantly improving the heat-up characteristics and thermal environment of CVD systems. They have tailorable electrical properties which make them well suited for inductive and conductive heating applications and electrical conductivity useful in plasma enhanced CVD. Carbon-carbon composites are not susceptible to outgassing, effectively reduce particulate formation during CVD processes and are reproducibly machinable to precise tolerances. Their thermal expansion can be tailored to match that of the material to be deposited. Silicon-coated carbon-carbon composites are suitably chemically inert even when subjected to oxidizing environments at CVD temperatures.

In the practice of the present invention, at least one CVD processing part, that is a reactor part, material handling part, or furniture item comprises carbon fiber reinforced carbon matrix material as aforesaid.

The present invention includes use of a carbon fiber reinforced carbon matrix body having a coating consisting essentially of silicon. Silicon may serve as a precoat to the deposition of a further refractory or other protective coating.

The invention will now be described in greater detail with reference to the accompanying drawings wherein:
Fig. 1 is a longitudinal section view of a LPCVD reactor.
Fig. 2 is an elevation view of a semiconductor wafer cage.
Fig. 3 is a longitudinal cross-section view of the wafer cage.
Fig. 4 is an elevation of the interior of the bottom part of a wafer cage.
Fig. 5 is an elevation view of the exterior of the top part of the wafer cage.
Fig. 6 is an exploded view of a bell jar CVD reactor.
Fig. 7 is an exploded elevation view of a PECVD reactor with wafer plates.
Fig. 8 is an elevation view of an "atmospheric" pressure CVD reactor.

Carbon fiber reinforced carbon matrix materials, or carbon-carbon composites, to be used in the manufacture of CVD processing parts employed in CVD processes for deposition of volatile chemical species on at least one semiconductor wafer have thermal stability as a solid, high resistance to thermal shock due to high thermal conductivity and low thermal expansion behaviour, and high toughness , strength and stiffness in high-temperature applications. Carbon-carbon composites may comprise carbon or graphite reinforcements mixed or contacted with matrix precursors to form a "green" composite, thereafter being carbonized to form the carbon-carbon composite. They may also comprise carbon or graphite reinforcements in which matrix is introduced fully or in part by chemical vapor infiltration.

The carbon or graphite reinforcements are commercially available from Amoco, DuPont, Hercules, Celanese and others, and can take the form of cloth, chopped cloth, yarn, chopped yarn, tape and felt. Yarns may be woven in desired shapes by braiding or by multidirectional weaving. The yarn, cloth and/or tape may be wrapped or wound around a mandrel to form a variety of shapes and reinforcement orientations. The fibers may be wrapped in the dry state or they may be impregnated with the desired matrix precursor prior to wrapping, winding, or stacking. Such prepreg and woven structures reinforcements are commercially available from BP Chemicals. The reinforcements are prepared from precursors such as polyacrylonitrile (PAN), rayon or pitch.

Matrix precursors which may be used to form carbon-carbon composites include: filled and unfilled phenolics, furans, pitches, organometallic resins and combinations thereof. Representative phenolics include, but are not limited to, resoles such as those supplied under the trademark SC 1008 by Borden Inc. and novolacs such as supplied by BP Chemicals under the trademark JT 7002. Representative furans include, but are not limited to, resins supplied by Quaker Oats under the trademark UP 520 or LP 520. Pitches are obtained from petroleum or coal refining and include, but are not limited to those supplied by Allied Chemical under trademark 515V and by Ashland Chemical under trademark 240. Representative organometallic resins include, but are not limited to, organozirconium resins such as those disclosed in U.S. Patent No. 4,585,837 and polysilane resins such as those disclosed in U.S. Patent No. 4,543,344.

Useful fillers include, but are not limited to, carbon, boron, silicon, boron carbide, silicon carbide titanium carbide, zirconium carbide, hafnium carbide, niobium carbide, tantalum carbide, tungsten carbide, silicon hexaboride, titanium boride, zirconium boride, hafnium boride, niobium boride, tantalum boride and tungsten boride.

The carbon-carbon composites useful in the present invention may be fabricated by a variety of techniques. Typically, resin impregnated carbon or graphite fibers are autoclave- or press-molded into the desired shape on a tool or in a die. The molded parts are heat-treated in an inert environment to temperatures from about 700°C to about 2900°C in order to convert the organic phases to carbon. The carbonized or graphitized parts are then densified by carbon and/or SiC chemical vapor impregnation or by multiple cycle reimpregnations with suitable polymers such as the pitch resins and/or other resins described above. Other fabrication methods include hot-pressing and the chemical vapor impregnation of dry preforms.

Methods of fabrication of carbon-carbon composites which may be used according to the present invention are described in U.S. patents 3,174,895 and 3,462,289, which are incorporated by reference herein.

Shaped carbon-carbon composite parts for CVD reactors, handling apparatus or furniture can be made either integrally before or after carbonization, or can be made of sections of material joined into the required shape, again either before or after carbonization.

Once the general shape of the carbon-carbon composite article is fabricated, the piece can be readily machined to precise tolerances. Whereas a quartz tube of a nominal 108 mm dimension can vary over a range of about 6 mm, a carbon-carbon composite can be machined to a tolerance on the order of about 0.1 mm or less. This is critical for CVD depositions in which the reaction is diffusion controlled and highly geometry dependent. Further, because of the strength and machinability of carbon-carbon composites, in addition to the shaping possible in the initial fabrication process, carbon-carbon composites can be formed into shapes for reactor parts, furniture and material handling apparatus or parts that are not possible with quartz or graphite.

A further advantage of the carbon-carbon composite CVD processing parts (reactor and/or material handling parts and furniture) is automation compatibility due to their high strength, dimensional stability and ability to be made to precise tolerances. These permit parts, such as furniture, reactor parts, jigging apparatus and other handling apparatus to be uniform enough to be grasped and manipulated by automated equipment.

Carbon-carbon composite parts and furniture can be used in CVD processes without first coating the part or item of furniture, although it is preferable to precoat the carbon-carbon composite before use in an oxidizing, or nitriding environment. Otherwise, such as in a CVD process to form SiO₂ or doped SiO₂ using uncoated carbon-carbon composite furniture, the mild oxidizing environment would cause an eroding of the surface by the formation of carbon oxides. For the deposition of silicon, however, the precoating is not required.

It is, however, preferable to coat the carbon-carbon composite CVD processing parts prior to use, in order to lock down any particles which may have formed as a result of the composite fabrication or machining process.

Whereas the art has recognized that graphite is difficult to coat with a refractory surface suitable for utility in CVD processes, refractory coatings on graphite being fragile and generally nonuniform, according to the present invention it has been found that carbon-carbon composites can readily be coated with a protective coating. The irregular surface of carbon-carbon composites permits the tenacious adherence of coatings, such as silicon carbide, silicon nitride, and doped or undoped silicon dioxide. Dopants could include phosphorus, useful in canceling or trapping impurities such as sodium. These can be deposited conventionally by chemical vapor deposition or can be prepared by physical vapor deposition (PVD). Whereas coatings are usually on the order of angstroms with graphite before spalling, coatings on carbon-carbon composites are adherent in thicknesses even on the order of mils. For protective coatings, thicknesses are about 1 to about 50 microns and preferably about 10 microns to about 50 microns.

Other protective coatings may include MoSi₂, WSi₂, ZrB₂, TiB₂, SiB₄, SiB₆, B₄C, B, Ni, Cr, Pt, Ir, NiSi₂, SiAlON, and oxide based coatings such as alumina, aluminophosphate, aluminosilicates, magnesium aluminosilicates, borosilicates, sodiumboroaluminosilicates, and combinations of the above, optionally with SiC, SiO₂ or Si₃N₄. Methods used to apply the above protective coatings can include known CVD, PVD, electroplating, plasma or flame spraying, pack cementation or conversion methods, sol-gel and slurry methods.

According to the present invention, additionally, it has been found that a layer of silicon can be deposited on carbonaceous bodies, particularly carbon-carbon composites, to protect the surface during CVD processes, and to serve as a precoat for an additional layer of refractory or other protective material. The silicon coating seals the surface of the carbon-carbon composite, and locks in any particles, impurities or deposits on the carbon surface.

The silicon can be deposited by chemical vapor deposition in an amorphous form or by physical vapor deposition, plasma spraying or flame spraying. A coating of about 0.1 microns to about 10 microns, preferably about 0.8 microns to about 10 microns is sufficient to protect the surface of the carbonaceous body, such as the carbon-carbon composite surface, during subsequent CVD operations by rendering the carbon surface less reactive in oxidizing environments. A coating of at least 0.5 microns is preferred to form a precoat for additional refractory or protective material deposition. If CVD is used to deposit the silicon coating, silane can be deposited at a temperature of about 580°C to about 650°C, preferably about 580°C to about 600°C, and a pressure of about 0.3 torr to about 0.7 torr, preferably about 0.4 torr to about 0.6 torr for about 2-1/2 to about 4 hours.

It is possible that under the CVD conditions, the silicon which is deposited on the carbonaceous material forms a thin film of silicon carbide at the silicon-carbon interface. However, additional amorphous silicon or polysilicon is deposited to form an adherent base for the coating of additional materials. The silicon layer is compliant and conforms to the surface of the body. Any microcracks which may develop in the refractory or protective overcoating will open to the silicon layer, which protects the carbon from the CVD process oxidizing, reducing or nitriding environments.

The overcoating layer can be prepared by conventional CVD processes, from a minimal thickness sufficient to stop diffusion of impurities from carbon or graphite and prevent etch back of the surface, up to any thickness which does not adversely affect a critical dimension of the carbon-carbon body. Materials suitable as refractory or protective overcoatings for CVD process reactor or handling apparatus parts and furniture include silicon carbide, silicon nitride, silicon dioxide either undoped or doped with boron, phosphorus or arsenic, and the additional protective coatings listed above as suitable for deposition on carbon-carbon composites.

The refractory or protective layer can also be provided in situ in the CVD reactor in which the body (neat or precoated) is functioning as a reactor part or item of furniture. As will be discussed below, the CVD processing of substrates using the carbon-carbon composite material as reactor parts or furniture in accordance with the present invention results in a relatively uniform deposition of CVD materials onto the carbon-carbon composite. These CVD materials may then serve as a further protective coating for the carbon-carbon composite.

If a protective or refractory coating is employed on the carbon-carbon composite according to the invention, it should be compatible with the material to be deposited on the substrate in the CVD process in which the carbon-carbon composite is utilized as a reactor part or furniture.

As an alternative embodiment of the invention, carbon or graphite fibers can be formed in a body using a polymer matrix. The polymer may then be charred in situ with an immediate deposition of silicon or silicon carbide being effected onto the fiber/char body from silane or dichorosilane.

Carbon-carbon composites and the related composite materials from which reactor parts and furniture for according to the present invention have CVD processes efficient and uniform heat transfer properties required for surface controlled reactions such as those encountered in LPCVD, being electrically conductive and are chemically inert as required for PECVD. Such materials are capable of formation and maintenance of precise and uniform tolerances critical to maintaining geometries for uniform deposition in LTO CVD. Most characteristics enumerated are important in all CVD processes for depositing volatile chemical species on semiconductor wafers, including resistance to high temperature and the chemical environment of the deposition (oxidizing, reducing, nitriding), all of which are possessed by coated carbon-carbon composite materials according to the present invention. Therefore, the suitability of carbon-carbon composite materials for low-temperature oxide CVD will be exemplified to more fully explain and describe the invention.

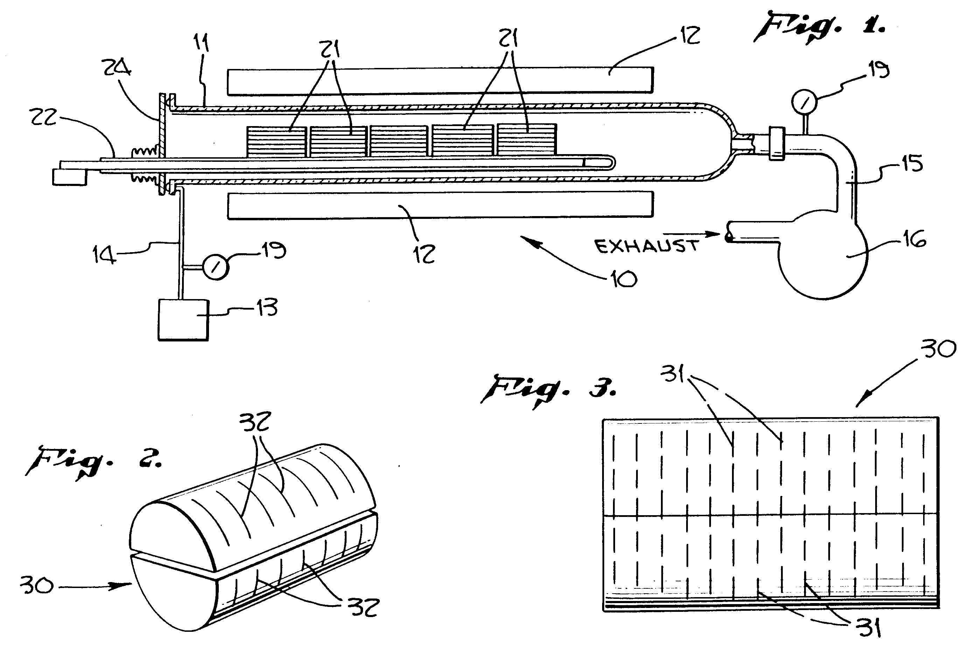

Fig. 1 depicts a LPCVD reactor 10 suitable for use in LTO depositions. Heater 12 is generally housed in a furnace tube (not shown) about 9 inches (about 23 cm) in diameter, and about 6 feet (about 1.8 m) long. Interior to the furnace tube is reactor tube 11, generally made of 6 to 8 inch (15.24 to 20.32 cm) diameter quartz about 8 feet (about 2.4 m) long, concentrically positioned interior to heater 12. A process gas source 13 is connected to the interior of reactor tube 11 by gas line 14, the position of the inlet being determined by the type of deposition to be effected, and exhaust line 15 exits the interior of reactor tube 11 in communication with pump 16. Pressure sensors 19 provide feedback control capabilities to achieve and maintain operating pressures. Carriers 21 are inserted for optimal heating into the hot central portion (front to back) of reactor tube 11 interior by cantilevered rods 22. Door 24 seals reactor tube 11 by means of gaskets (not shown).

For surface controlled CVD processes such as the deposition of polysilicon, silicon nitride and tetraethylorthosilicate, the carrier can be a slotted tray, an open boat or a "nest," made of carbon-carbon composite material and holding one semiconductor wafer substrate per slot, usually centered about 3/16 to 3/8 inch (0.48 to 0.96 cm) apart.

Another type of furniture which can be fabricated from carbon-carbon composite materials is wafer cage 30 shown in Fig. 2. Wafer cages 30 are typically made in two sections, shown partly opened to permit insertion and removal of semiconductor wafers 31 represented by the dashed lines in Fig. 3 and held in slots (not shown) in the cage. Wafer cage 30 completely encases the semiconductor wafers 31, except for radial diffusion ports 32 which are open to the exterior and allow process gas to enter and exit wafer cage 30 during the CVD process.

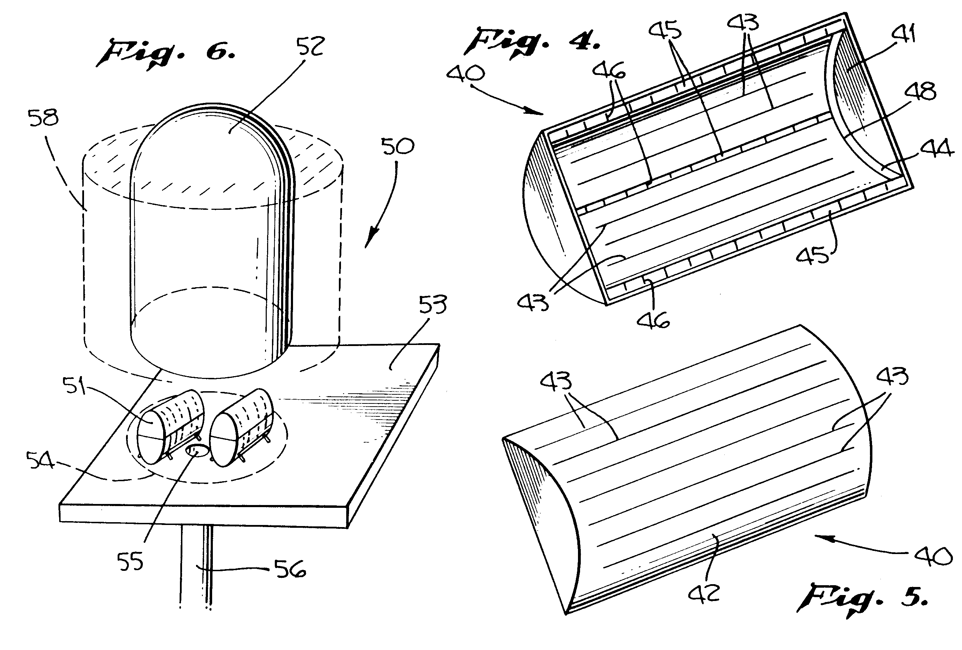

An alternative wafer cage 40 is shown in an open position as a bottom portion 41 in Fig. 4 and a top portion 42 in Fig. 5. This wafer cage has longitudinal diffusion ports 43, which generally are spaced apart radially with respect to the long axis of cage 40 by an angle of 20°. The bottom portion 41 holds a wafer nest 44 comprised of rails 45 having slots 46 for holding semiconductor wafers (not shown). Rails 45 may be joined by an end piece 48. Nests 44 typically have two to four rails 45 and may be integral with cage 40 or may be removable for easy access to the wafers. If removable, it is preferred that nest 44 fit loosely into case bottom portion 41. Slots 46 are centered equidistantly from adjacent slots, generally 3/8 inches or 9/16 inches apart.

Both the wafer cage and nest or rails can be fabricated from carbon-carbon composite materials according to the invention. While the thermal characteristics of these materials are advantageous, surface activation has a second order effect in LTO CVD processes, which are controlled by geometry and diffusion of the process gas. The ability of the carbon-carbon composite materials to be fabricated with and maintain precise tolerances (even within 3 mils (7.6 x 10⁻³ cm)) provides the uniform geometry and diffusion paths required.

### Furniture

There are over one hundred different pieces of deposition furniture currently marketed for the fabrication of CVD coatings on semiconductor substrates. These can advantageously be made from carbon-carbon composite materials to avoid outgassing, reduce particle formation and to maintain strength and dimensional stability at temperature and reaction conditions.

The following Examples illustrate this invention:

### Example 1

A wafer cage was prepared from carbon-carbon composite material comprising a 50 mil (0.13 cm) thick laminate composed of carbon fabric in an essentially pure carbon matrix. The fabric was derived from a polyacrylonitrile precursor, such as that available from Amoco Chemical under the tradename T-300 (8 harness satin weave). The matrix material was derived from a phenolic resin precursor. Both the carbon fabric and matrix materials were densified with pyrolitic carbon by chemical vapor infiltration. The carbon-carbon composite material had a rated flexural strength near 45 KSI and notched izod impact strengths in the range of 8-14 lbf.in (9-15.8 Nm). The cage was coated with silicon by CVD of silane (150 sccm) at 0.5 torr and 580°C for 4 hours.

The carbon-carbon composite wafer cage was fitted with a nest of three carbon-carbon rails which were machined on a mill from a flat carbon-carbon composite panel and coated with silicon by CVD as above. Semiconductor wafers of 100 mm by 22 mil (0.06 cm) of silicon were loaded into the carbon-carbon composite cage, and it was tested in an LTO, PSG LPCVD process.

One carbon-carbon composite wafer cage loaded with 18 semiconductor wafers was loaded into a LPCVD reactor tube together with 4 quartz wafer cages, similarly loaded. Over several runs, the carbon-carbon composite cage was moved to different positions front to back among the five cages to eliminate possible bias due to position in the reactor.

The five cages each containing 18 semiconductor wafers, including the carbon-carbon composite cage, were run in an LTO process for the deposition of phosphorus doped silicon dioxide. The tests were conducted at a run temperature of about 420°C and a pressure of about 0.275 torr to about 0.285 torr. The process gas was generally about 34% silane, about 66% oxygen and .0015% phosphine (nitrogen was used as a carrier gas for the phosphine) by volume.

The depositions resulted in good films being deposited on the semiconductor wafers in the carbon-carbon composite cages. The weight percent of phosphorus doped into the films was about 3.1%, the same as for the semiconductor wafers processed in the quartz cages. The total thickness of the deposited layer was slightly less (about 10%) for the carbon-carbon cage-held wafers versus the quartz-cage held wafers, as a result of the enhanced affinity of the carbon-carbon composite material for film deposition from the process gas. This is readily compensated for in a deposition system using only carbon-carbon composite cages, by increasing deposition time, flow rates and the like.

The wafer surfaces were analyzed for four CVD runs and calculations made to determine the number of particles of about 1 micron and about 2 micron sizes which developed on the wafer during deposition. The surfaces were analyzed by a surface scanning reflection apparatus (tradename "Surfscan") before and after deposition for the center wafer in each cage. The difference between the amounts of each size particles were added for the quartz cage-held wafers as compared to the carbon-carbon composite cage-held wafers to neutralize cage-position effects, and the amounts were averaged according to the number of wafers scanned. The semiconductor wafers which were CVD coated with phosphorus doped silicon dioxide in carbon-carbon composite cages showed a reduction of 17% in the number of one micron size particles and a 37% reduction in the amount of two micron size particles deposited on the wafer surfaces as compared to those processed in quartz cages.

### Reactor.

During the CVD process, for example in the operation of the LPCVD reactor depicted in Fig. 1, the material to be deposited forms not only on the wafers but also on cages 21, walls of reactor tube 11 and any other reactor parts exposed to the process gas, such as the cantilevered rods 22. Cooler temperatures promote particle formation over film deposition, which results not only in the difficulties with particles being carried onto the wafer surface, but also in the eventual agglomeration of particles on the surfaces of the reactor parts and cages which interfere with operation and which must be eliminated by HF bath cleaning.

Cooler temperatures result from position of the part in the reactor as well as the material of construction. While the central portion of reactor tube 11 is held at the process temperature, neither end of the tube simultaneously experiences the same temperature (thus, water cooling is possible to permit door 24 to be made of stainless steel). The process gases therefore experience a transition in temperature from lower at the inlet to high in the center and decreasing again at the outlet. The character of deposition is different at the different temperatures and on the different surfaces.

In order to determine the time for cleaning of the reactor parts and cages, a record of the total deposition thickness upon the wafers over consecutive runs is tracked, taking into account that there will be much greater deposition on the reactor tube and parts than on the wafers. Cleaning of the reactor is generally required after every 20-30 depositions, resulting in much reactor downtime.

### Example 2

In an actual LPCVD reactor such as depicted in Fig. 1, having cantilevered rods made of 1-inch (2.54 cm) diameter alumina (covered with quartz sheaths), the rods measured about 27 inches (about 68.5 cm) from the closest wafer cage to the door. A 10 mil (0.025 cm) thick carbon-carbon composite ply (of the material described in example 1) was coated with silicon by CVD under the conditions of example 1 to a thickness of at least about 0.5 microns to about 0.8 microns. The silicon coated carbon-carbon composite fabric was slid over the rods from about one inch (2.54 cm) away from the closest cage to a length of 14 inches (35.5 cm) toward the door. An LTO CVD process was conducted for the deposition of phosphorus doped silicon dioxide onto semiconductor wafers in quartz cages.

The semiconductor wafers were deposited with the required coating. In the reactor tube outside the cages, an adherent film deposition occurred on the carbon-carbon composite material to the exclusion of the portion of the cantilevered rods not covered by the fabric and the quartz reactor tube. Very limited deposition on the walls of the quartz tube and very limited particle formation was observed.

The carbon-carbon composite material, having excellent radiation heat transfer properties, served as a black body to heat quickly and cause film deposition on its surface to the exclusion of particle formation on cooler reactor surfaces.

The use of carbon-carbon composite materials, either as reactor parts such as rods, rails, susceptors, conductive plates, gas manifolds, vacuum lines and the like, or as even a partial covering for any of those parts would result in the reactor tube being useful for a large number of operations with only very infrequent cleanings.

### Example 3

Conventional wafer cages made of quartz can generally be used for only 5-8 depositions before the resulting particle agglomeration must be cleaned in hydrofluoric acid, with the breakage factor noted above and limited cage life. Cages made of other materials also exhibit fragility and/or need frequent cleaning. The carbon-carbon composite wafer cage described in Example 1 has run for 50 LTO deposition operations with an adherent deposition of a uniform silicon dioxide film. After 50 depositions, the coating of silicon dioxide was still adherent. It is estimated that no less than 5-6 mils (0.013 - 0.015 cm) could be deposited before the carbon-carbon composite wafer cage required cleaning or replacement. Frequent cleanings with HF would be avoided, together with their attendant handling and disposal problems. Even if no cleaning of the carbon-carbon composite cages were desired, the useful life of the cage is estimated to be at least 10 times that of quartzware. Disposal of the used cages would be environmentally friendly, as they could be treated as nonhazardous material.

Carbon-carbon composite materials have now been run successfully in BSG, PSG and BPSG LTO CVD processes, polysilicon and doped polysilicon CVD, and silicon nitride CVD.

### Other Embodiments

In addition to the embodiments described above, carbon-carbon composite materials according to the present invention are useful in additional CVD systems for depositing volatile chemical species on at least one semiconductor wafer, including those described in the Background of the Invention, and for other types of furniture and material jigging of handling parts.

The materials are useful in bell jar reactors, such as that sold by ANICON. Such a bell jar reactor 60 is depicted in Fig. 6. Wafer cages 51 are contained between bell jar 52 and base 53, sealed with an o-ring 54. Extending up from base 53 is a gas manifold (not shown) which introduces process gas into the reactor. The gas passes into wafer cages 51, and may be preferentially directed into the cages by shrouds (not shown) which are disposed adjacent to the cages. Gas is removed through outlet 55 to vacuum line 56. Heater 58 surrounds bell jar 52.

This bell jar system is used for depositing P-doped polysilicon at temperatures of about 550°C to about 700°C (preferably about 680°C) and pressures of about 0.3 torr. P-doped and B- & P-doped silicon oxide can be deposited at similar pressure and at about 400°C. Wafer cages 51, the gas manifold and shrouds, among other furniture and parts, may be made of carbon-carbon composite materials according to the present invention.

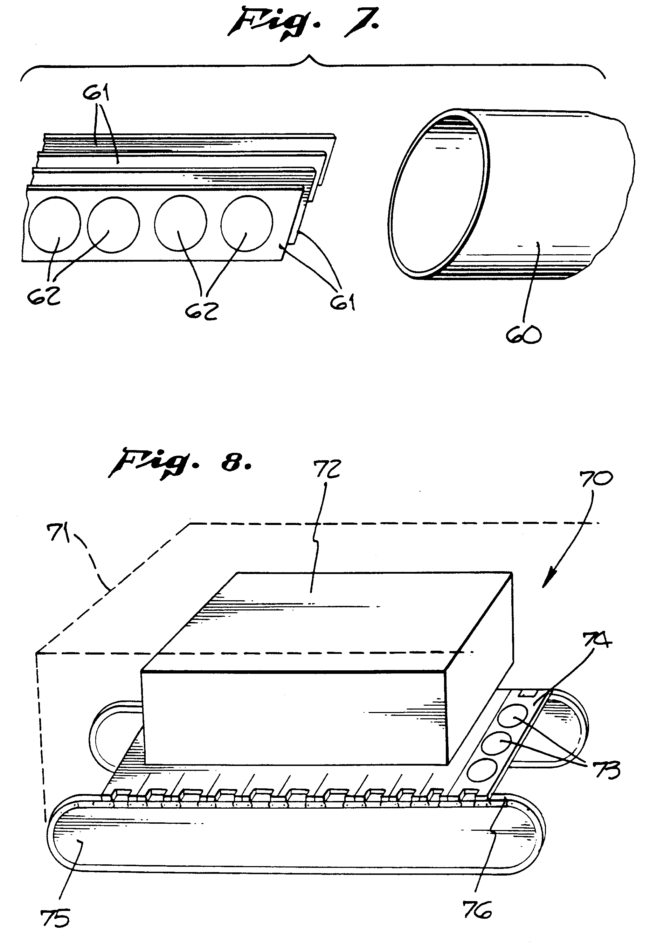

The carbon-carbon composite CVD process parts are suitable for plasma-enhanced CVD. Fig. 7 depicts reactor tube 60 into which parallel plates 61 are inserted. Plates 61 can be made of carbon-carbon composite materials according to the present invention as described above. The plates have pockets machined into them to hold semiconductor wafers 62, which normally face each other between plates 61. Carbon-carbon composite screws (not shown) can hold wafers 62 in place. Plates 61 are held in spaced relation and subjected to alternate potentials of RF ground and positive or RF negative and positive.

A plasma is struck between the plates at pressures of about 0.3 to about 0.5 torr in Ar or Ar/N₂. Amorphous silicon can be deposited in this way at about 250°C, and silicon nitride or silicon dioxide can be deposited at about 350° to about 420°C.

In a high-pressure ("atmospheric") reactor 70, as shown in Fig. 8, such as that produced by Applied Materials, deposition takes place in vented chamber 71 via deposition head 72 comprised of gas manifolds. The semiconductor wafers 73 are carried in machined pockets on trays 74 between deposition head 72 and a heater (not shown) by chains 76 held on chain track 75. In this type of reactor, trays and the chain track, for example, can be made of carbon-carbon composite material according to the present invention described above.

The carbon-carbon composite trays would stay flat at the operating temperatures of 475°C to 500°C, having dimensional stability, unlike the anodized stainless steel or black oxidized nickel trays now in use. Also, the carbon-carbon composite trays would heat quickly and uniformly, avoiding temperature overshoot which can harm the wafers if 460°C is exceeded (wafer temperature is usually about 420°C.)

Carbon-carbon composite materials as described above can also be used for open or closed boat systems used for the doping of semiconductor wafers by solid planar diffusion dopant sources in a diffusion furnace.

It is therefore apparent from the foregoing description that carbon-carbon composite materials are advantageously useful in the CVD processes described throughout this specification, under the temperature and pressure conditions and chemical and electrical environments normally utilized for the processes. The carbon-carbon materials contribute to process uniformity through efficient heat transfer, and deposits which form on the carbon-carbon composites during CVD processing tightly adhere to the carbon-carbon composite and do not contribute to particle contamination.

The carbon-carbon composite materials can thus be utilized for CVD processing parts generally, which, for purposes of this specification, include reactor parts, handling and jigging apparatus or parts, deposition furniture and coverings for all the above. Illustrative examples include, but are not intended to limit the scope of the invention, carriers, wafer cages, boats, trays, nests, rails, rods, susceptors, plates, conductive plates, gas manifolds, shrouds and feed lines and vacuum lines.

It is apparent that the inventive process and materials provide an advancement in the art as described above. The foregoing examples and descriptions, such as precursor materials, fabrication methods, coatings, types of CVD processes in which the aforementioned carbon-carbon composite materials may be used, reaction conditions and the like, are meant to illustrate and not limit the invention, which includes all modifications and variations that fall within the scope of the following claims and their equivalent embodiments.

## Claims

1. A chemical vapour deposition process for the uniform deposition of one or more volatile species onto at least one semiconductor wafer, characterised in that the process is modified by having at least one CVD processing part in direct contact with the semiconductor wafer, said at least one CVD part comprising a carbon fibre-reinforced carbon matrix material providing dimensional stability to said part and being capable of maintaining precise tolerances as temperatures change and when subject to reaction conditions, whereby film deposition is promoted over particle formation during the chemical vapour deposition, thereby avoiding outgassing and suppressing impurity particle formation on the semiconductor wafer.

2. A process as in claim 1, wherein the CVD processing part comprises carbon fibre selected from carbon fibre, graphite fibre and mixtures thereof as reinforcement.

3. A process as in claim 1 or 2 wherein the carbon fibre reinforced carbon matrix material has a protective coating thereon.

4. A process as in claim 3 wherein said coating contains a precoat layer consisting essentially of silicon.

5. A process as in claim 4 wherein silicon carbide is present at the interface between the material and the silicon precoat.

6. A process as in claims 3, 4 or 5 wherein the protective coating is selected from the group consisting of SiC, doped or undoped SiO₂, Si₃N₄, SiAlON, MoSi₂, WSi₂, NiSi₂, ZrB₂, TiB₂, SiB₄, SiB₆, B₄C, B, Ni, Cr, Pt, Ir, alumina, aluminophosphate, aluminosilicates, preferably magnesium aluminosilicates, borosilicates, preferably sodium boroaluminosilicates, and combinations thereof.

7. A process as in any one of claims 1-6 wherein the matrix material contains a filler.

8. A process as in any one of claims 1-7 wherein the processing part is a reactor part, a handling or jigging part, or a covering therefor.

9. A process as in any one of claims 1-7 wherein the processing part is CVD furniture or a covering therefor.

10. A process as in claim 9 wherein the CVD furniture is a wafer carrier.

11. A process as in claim 10 wherein the wafer carrier is a wafer cage, an open wafer boat, a closed wafer boat, a wafer tray, a wafer nest or a wafer rail.

12. A process as in claim 8 wherein the CVD processing part is a cover, rod, track, screw, susceptor, plate, conductive plate, gas manifold, shroud, fuel line or vacuum line.

13. A process as in any of the preceding claims wherein there is deposition on the semiconductor wafer of polysilicon, doped polysilicon, silicon nitride, borosilicate glass, phosphosilicate glass, borophosphosilicace glass, amorphous silicon, SiO₂, doped SiO₂, SiO₂-Si₃N₄, epitaxy Si, tetraethylorthosilicate, phosphorus doped SiO₂, or boron doped SiO₂.

14. A process as in any one of the preceding claims wherein the chemical vapor deposition process is low pressure CVD, a plasma-enhanced CVD or a high pressure CVD.

## Patentansprüche

1. Verfahren zur chemischen Abscheidung aus der Gasphase (CVD) zur gleichmäßigen Abscheidung von einem oder mehreren flüchtigen Bestandteilen auf mindestens einen Halbleiterwafer, **dadurch gekennzeichnet**, daß das Verfahren modifiziert ist, indem es mindestens einen CVD-Verfahrensteil in direktem Kontakt mit dem Halbleiterwafer hat und dieses mindestens eine CVD-Teil ein kohlefaserverstärktes Kohlenstoffmatrixmaterial enthält, welches diesem Teil Dimensionsstabilität verleiht und in der Lage ist, genaue Toleranzen bei Änderung der Temperaturen und beim Unterwerfen unter Reaktionsbedingungen einzuhalten, wodurch eine Filmabscheidung über Ausbildung von Teilchen während der chemischen Abscheidung aus der Dampfphase gefördert wird und auf diese Weise ein Entgasen vermieden und die Bildung unreiner Teilchen auf dem Halbleiterwafer unterdrückt wird.

2. Verfahren nach Anspruch 1,
in welchem das CVD-Verfahrensteil Kohlenstoffasern, ausgewählt aus Kohlefasern, Graphitfasern und Mischungen derselben als Verstärkung enthält.

3. Verfahren nach einem der Ansprüche 1 oder 2,
in welchem das kohlefaserverstärkte Kohlenstoffmatrixmaterial einen Schutzüberzug aufweist.

4. Verfahren nach Anspruch 3,
in welchem der Überzug eine Vorüberzugsschicht, bestehend im wesentlichen aus Silicium aufweist.

5. Verfahren nach Anspruch 4,
in welchem Siliciumcarbid an der Grenzfläche zwischen dem Material und der Silicium-Vorüberzugsschicht ausgebildet ist.

6. Verfahren nach den Ansprüchen 3, 4 oder 5,
in welchem der Schutzüberzug aus der Gruppe, bestehend aus SiC, dotiertem oder undotiertem SiO₂, Si₃N₄, SiA1ON, MoSi₂, WSi₂, NiSi₂, ZrB₂, TiB₂, SiB₄, SiB₆, B₄C, B, Ni, Cr, Pt, Ir, Aluminiumoxid, Aluminiumphosphat, Aluminiumsilikaten, vorzugsweise Magnesium-Aluminiumsilikaten, Borsilikaten, vorzugsweise Natriumbor-Aluminiumsilikaten und Kombinationen derselben ausgewählt ist.

7. Verfahren nach einem der Ansprüche 1 bis 6,
in welchem das Matrixmaterial einen Füllstoff enthält.

8. Verfahren nach einem der Ansprüche 1 bis 7,
in welchem das Verfahrensteil ein Reaktorteil, ein Handhabungs- oder Aufspannteil oder eine Abdeckung hierfür ist.

9. Verfahen nach einem der Ansprüche 1 bis 7,
in welchem das Verfahrensteil eine CVD-Ausrüstung oder eine Abdeckung dafür ist.

10. Verfahren nach Anspruch 9,
in welchem die CVD-Ausrüstung ein Waferträger ist.

11. Verfahren nach Anspruch 10,
in welchem der Waferträger ein Waferkäfig, ein offenes Waferboot, ein geschlossenes Waferboot, eine Waferschale, ein Wafernest oder eine Waferschiene ist.

12. Verfahren nach Anspruch 8,
in welchem das CVD-Verfahrensteil eine Abdeckung, Stange, Schiene, Schraube, Aufnahme, Platte, leitende Platte, Gasleitung, Ummantelung, Treibstoffleitung oder Vakuumleitung ist.

13. Verfahren nach einem der vorherigen Ansprüche,
in welchem Abscheidung von Polysilicium, dotiertem Polysilicium, Siliciumnitrid, Borsilikatglas, Phosphorsilikatglas, Borphosphorsilikatglas, amorphem Silicium, SiO₂, dotiertem SiO₂, SiO₂-Si₃N₄, epitaxialem Si, Tetraethylorthosilikat, Phosphor dotiertem SiO₂ oder Bor dotiertem SiO₂ auf den Halbleiterwafer erfolgt.

14. Verfahren nach einem der vorherigen Ansprüche,
in welchem das Verfahren zur chemischen Abscheidung aus der Gasphase ein Niederdruck-CVD-Verfahren, ein Plasma gesteigertes CVD-Verfahren oder ein Hochdruck-CVD-Verfahren ist.

## Revendications

1. Procédé de dépôt chimique en phase gazeuse (CVD), pour l'obtention d'un dépôt uniforme d'une ou plusieurs espèces volatiles sur au moins une tranche de semi-conducteur, caractérisé en ce que le procédé est modifié par le fait qu'au moins une partie du dispositif pour le procédé CVD est en contact direct avec la tranche de semiconducteur, ladite au moins une partie du dispositif pour le procédé CVD comprenant un matériau constitué d'une matrice de carbone renforcée par des fibres de carbone, qui apporte la stabilité dimensionnelle à ladite partie et est capable de conserver des tolérances précises lorsque la température change et qu'il est soumis aux conditions de réaction, grâce à quoi le dépôt d'un film est favorisé par rapport à la formation de particules lors du dépôt chimique en phase gazeuse, ce qui permet d'éviter le dégazage et de supprimer la formation de particules impuretés sur la tranche de semi-conducteur.

2. Procédé selon la revendication 1, dans lequel la partie du dispositif pour le procédé CVD renferme des fibres de carbone choisies parmi les fibres de carbone, les fibres de graphite et leurs mélanges, comme fibres de renforcement.

3. Procédé selon la revendication 1 ou 2, dans lequel le matériau constitué d'une matrice de carbone renforcée par des fibres de carbone, est revêtu d'un revêtement protecteur.

4. Procédé selon la revendication 3, dans lequel ledit revêtement contient une couche de prérevêtement, constituée essentiellement de silicium.

5. Procédé selon la revendication 4, dans lequel du carbure de silicium est présent à l'interface entre le matériau et le prérevêtement de silicium.

6. Procédé selon l'une quelconque des revendications 3 à 5, dans lequel le revêtement protecteur est choisi parmi les revêtements constitués de SiC, SiO₂ dopé ou non dopé, Si₃N₄, SiAlON, MoSi₂, WSi₂, NiSi₂, ZrB₂, TiB₂, SiB₄, SiB₆, B₄C, B, Ni, Cr, Pt, Ir, l'alumine, les aluminophosphates, les aluminosilicates, de préférence les aluminosilicates de magnésium, les borosilicates, de préférence les boroaluminosilicates de sodium, ou leurs combinaisons.

7. Procédé selon l'une quelconque des revendications 1 à 6, dans lequel la matrice du matériau renferme une charge.

8. Procédé selon l'une quelconque des revendications 1 à 7, dans lequel la partie du dispositif pour le procédé est une partie du réacteur, une partie pour la manipulation ou l'oscillation, ou une enveloppe pour cette partie.

9. Procédé selon l'une quelconque des revendications 1 à 7, dans lequel la partie du dispositif pour le procédé est un accessoire pour CVD ou une enveloppe pour cet accessoire.

10. Procédé selon la revendication 9, dans lequel l'accessoire pour CVD est un porte-tranche.

11. Procédé selon la revendication 10, dans lequel le porte-tranche est une cage pour tranche, une nacelle ouverte pour tranche, une nacelle fermée pour tranche, un plateau pour tranche, un nid pour tranche ou un rail pour tranche.

12. Procédé selon la revendication 8, dans lequel la partie du dispositif pour le procédé CVD est un couvercle, une tige, une piste, une vis, un suscepteur, une plaque, une plaque conductrice, une canalisation de gaz, un bouclier, une conduite à combustible ou une conduite à vide.

13. Procédé selon l'une quelconque des revendications précédentes, dans lequel on effectue le dépôt de silicium polycristallin, de silicium polycristallin dopé, de nitrure de silicium, de verte au borosilicate, de verte au phosphosilicate, de verte au borophosphosilicate, de silicium amorphe, de SiO₂, de SiO₂ dopé, de SiO₂-Si₃N₄, de Si épitaxial, d'orthosilicate de tétraéthyle, de SiO₂ dopé par du phosphore ou de SiO₂ dopé par du bore, sur la tranche de semi-conducteur.

14. Procédé selon l'une quelconque des revendications précédentes, dans lequel le procédé de dépôt chimique en phase gazeuse est un procédé CVD basse pression, un procédé CVD utilisant un plasma ou un procédé CVD haute pression.
